(19) Europäisches Patentamt
European Patent Office
Office européen des brevets

(11) EP 4 722 315 A1

(12) **EUROPEAN PATENT APPLICATION**
published in accordance with Art. 153(4) EPC

(43) Date of publication:
**08.04.2026 Bulletin 2026/15**

(21) Application number: **24819512.5**

(22) Date of filing: **20.05.2024**

(51) International Patent Classification (IPC):
***C09G 1/02*** (2006.01) ***C09K 3/14*** (2006.01)
***H01L 21/3105*** (2006.01) ***B24B 37/04*** (2012.01)

(52) Cooperative Patent Classification (CPC):
**B24B 37/04; C09G 1/02; C09K 3/14; H10P 95/00**

(86) International application number:
**PCT/KR2024/006818**

(87) International publication number:
**WO 2024/253360 (12.12.2024 Gazette 2024/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.06.2023 KR 20230072080**

(71) Applicant: **SK enpulse Co., Ltd.**
**Seongnam-si, Gyeonggi-do 13453 (KR)**

(72) Inventors:
- **HAN, Deoksu**
**Seoul 03142 (KR)**
- **HONG, Seung Chul**
**Seoul 03142 (KR)**
- **KANG, Hyangan**
**Seoul 03142 (KR)**
- **JI, Hyesung**
**Seoul 03142 (KR)**
- **LEE, Hyung Joo**
**Seoul 03142 (KR)**
- **CHOI, Yongsoo**
**Seoul 03142 (KR)**

(74) Representative: **Isarpatent**
**Patent- und Rechtsanwälte PartG mbB**
**Friedrichstraße 31**
**80801 München (DE)**

(54) **COMPOSITION FOR SEMICONDUCTOR PROCESS, METHOD FOR PREPARING COMPOSITION FOR SEMICONDUCTOR PROCESS, AND METHOD FOR MANUFACTURING SEMICONDUCTOR DEVICE**

(57) Provided is a composition for a semiconductor process, comprising silica particles and having a relation 1 value of 6.30-9.60%. In addition, provided is a composition for a semiconductor process, comprising silica particles and having a relation 2 value of greater than 5.80% and less than 8.80%. Additionally, provided is a method for preparing the composition for a semiconductor process, comprising the steps of: (a) stirring a silica dispersion aqueous solution having a hydrogen ion concentration (pH) of 4.0 to 5.5; (b) when the temperature of the silica dispersion aqueous solution is higher than or equal to 25°C and lower than 40°C, injecting a silica surface modifier containing an amino silane component; (c) injecting a hydrogen ion concentration (pH) adjuster into the silica dispersion aqueous solution into which the silica surface modifier has been injected; and (d) stirring the silica dispersion aqueous solution, into which the hydrogen ion concentration (pH) adjuster has been injected, so that the final reaction temperature is 50°C to 65°C. In addition, provided is a method for manufacturing a semiconductor device to which the composition for a semiconductor process is applied.

【FIG. 1】

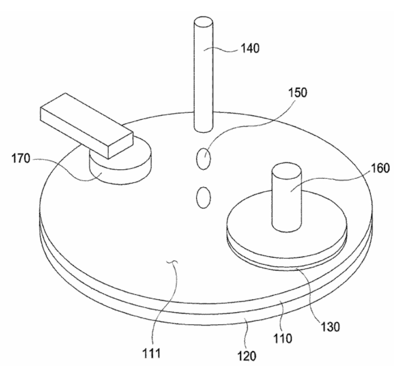


EP 4 722 315 A1

## Description

[Technical Field]

The present invention relates to a composition applicable to a semiconductor manufacturing and processing process, and more specifically, to a composition applicable to a polishing process during semiconductor manufacturing and processing, and a method of preparing the same.

[Background Art]

Chemical Mechanical Polishing (CMP) is a technology that polishes the surface of a sample to a target level by injecting a polishing slurry into an interface between a polishing pad and a polishing target while causing friction between the polishing pad and the surface of the polishing target. As modern chemical mechanical polishing is applied to the manufacture of large-scale semiconductor integrated circuits, it is being used as an essential technology for planarization of the surfaces of interlayer insulating films of devices such as transistors and multilayer wirings, planarization of various films such as oxide films and nitride films, or formation of tungsten or copper wirings. As the integration density of semiconductor devices increases and chip size decreases every year, the surface structure of semiconductor devices becomes more complex, and step differences between interlayer films become larger. Accordingly, high-resolution lithography and atomic-level planarization technologies are required for the CMP process applied to the manufacturing process of semiconductor devices. This CMP process is a process of planarizing films by simultaneously utilizing physical frictional force and chemical reaction, and can produce completely different polishing results even due to minute differences in process parts and/or process liquids utilized therein. Therefore, the precision required for the manufacture and design of such process components and/or process liquids is being improved to a higher level.

[Disclosure]

[Technical Problem]

Therefore, the present invention has been made in view of the above problems, and it is one object of the present invention to provide a composition for a semiconductor process including silica particles obtained through optimization of a surface modification process, wherein particle aggregation behavior is optimized for polishing a polishing target including a silicon oxide film and, at the same time, stability of the composition is improved. The composition for a semiconductor process can maximize these technical advantages by allowing the number of particles having a size equal to or larger than a predetermined size to fall within a predetermined range of a specific equation.

It is another object of the present invention to provide a method of preparing a composition for a semiconductor process, and to provide a method specialized for preparing a composition for a semiconductor process having the above-described technical advantages and effects.

It is yet another object of the present invention to provide a method of manufacturing a semiconductor device, wherein, when a semiconductor wafer having a structure requiring simultaneous polishing of a tungsten (W) film and a silicon oxide film is used as a polishing target by applying the composition for a semiconductor process to a polishing process, a polishing selectivity ratio of the silicon oxide film relative to the tungsten film can be implemented within an optimal range, and a semiconductor device having improved quality can be manufactured without defects such as scratches derived from aggregates or impurities in the composition for a semiconductor process during the polishing process.

[Technical Solution]

In accordance with an aspect of the present invention, the above and other objects can be accomplished by the provision of a composition for a semiconductor process, including silica particles and having a value of 6.30% to 9.60% according to Equation 1 below:

[Equation 1]

$$\frac{(L3+L5)}{L1} \times 100$$

where L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

In accordance with another aspect of the present invention, there is provided a composition for a semiconductor process, including silica particles and having a value of greater than 5.80% and less than 8.80% according to Equation 2 below:

[Equation 2]

$$\frac{(L3+L5)}{(L1+L3+L5)} \times 100$$

where L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

The composition may have a value of 4.50 to 10.00 according to Equation 3 below:

[Equation 3]

$$\frac{Rox}{(L1+L2+L3)}$$

where L1 is an LPC value of particles having a particle diameter of greater than 1 um in the composition for a semiconductor process, L3 is an LPC value of particles having a particle diameter of greater than 3 um in the composition for a semiconductor process, L5 is an LPC value of particles having a particle diameter greater than 5 um in the composition for a semiconductor process, and Rox is a polishing rate (Å/min) value of a silicon oxide film polished under conditions of a polishing pressure of 2 psi using the composition for a semiconductor process, a rotation speed of 120 rpm of a carrier mounted with a polishing target, a rotation speed of 120 rpm of a platen mounted with a polishing pad, and an injection rate of 300 ml/min of the composition for a semiconductor process.

The composition for a semiconductor process may further include at least one type of additive, wherein the additive includes one selected from the group consisting of an azole-based compound, a fluorine-based compound, an alcohol compound, an organic acid, an inorganic acid, and a combination thereof.

The silica particles may have a zeta potential of +10 mV to +40 mV in the composition for a semiconductor process.

In accordance with still another aspect of the present invention, there is provided a method of preparing a composition for a semiconductor process, the method including: step (a) of stirring an aqueous silica dispersion solution having a hydrogen ion concentration (pH) in a range of 4.0 to 5.5; step (b) of introducing a silica surface modifier containing an aminosilane component when a temperature of the aqueous silica dispersion solution is in a range of 25°C or higher and lower than 40°C; step (c) of introducing a hydrogen ion concentration (pH) adjuster into the aqueous silica dispersion solution into which the silica surface modifier has been introduced; and step (d) of stirring the aqueous silica dispersion solution, into which the hydrogen ion concentration (pH) adjuster has been introduced, such that a final reaction temperature reaches one in a range of 50°C to 65°C.

In step (a), the aqueous silica dispersion solution may be stirred at a speed of 500 rpm to 3000 rpm.

The hydrogen ion concentration (pH) adjuster may include an acid component and a solvent, wherein a weight ratio of the acid component to the solvent is 1:1 to 1:15.

In accordance with still another aspect of the present invention, there is provided a method of manufacturing a semiconductor device, the method including: disposing a to-be-polished surface of a polishing target to be in contact with a polishing surface of a polishing pad; injecting a composition for a semiconductor process into a contact interface between the polishing surface and the to-be-polished surface; and polishing the to-be-polished surface while rotating the polishing pad and the polishing target relative to each other, wherein the composition for a semiconductor process has a value of 6.30% to 9.60% according to Equation 1 below:

[Equation 1]

$$\frac{(L3+L5)}{L1} \times 100$$

where L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

In accordance with yet another aspect of the present invention, there is provided a method of manufacturing a semiconductor device, the method including: disposing a to-be-polished surface of a polishing target to be in contact with a polishing surface of a polishing pad; injecting a composition for a semiconductor process onto the polishing surface; and polishing the to-be-polished surface while rotating the polishing pad and the polishing target relative to each other, wherein the composition for a semiconductor process has a value of greater than 5.80% and less than 8.80% according to Equation 2 below:

[Equation 2]

$$\frac{(L3+L5)}{(L1+L3+L5)} \times 100$$

where L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

The composition for a semiconductor process may be injected onto the polishing surface at a flow rate of 10 mL/min to 1,000 mL/min.

Rotation speeds of the polishing pad and the polishing target may each independently be 10 rpm to 500 rpm.

[Advantageous effects]

As a composition for a semiconductor process according to the present invention includes silica particles obtained through optimization of a surface modification process, particle aggregation behavior can be optimized for polishing a polishing target including a silicon oxide film and, at the same time, stability of the composition can be improved. The composition for a semiconductor process can maximize these technical advantages by allowing the number of particles having a size equal to or larger than a predetermined size to fall within a predetermined range of a specific equation.

A method of preparing a composition for a semiconductor process according to the present invention is specialized for preparing a composition for a semiconductor process having the above-described technical advantages and effects.

When a semiconductor wafer having a structure requiring simultaneous polishing of a tungsten (W) film and a silicon oxide film is used as a polishing target by applying the composition for a semiconductor process to a polishing

process, the method of manufacturing a semiconductor device can implement a polishing selectivity ratio of the silicon oxide film relative to the tungsten film within an optimal range, and can manufacture a semiconductor device having improved quality without defects such as scratches derived from aggregates or impurities in the composition for a semiconductor process during the polishing process.

[Description of Drawings]

FIG. 1 schematically illustrates an apparatus configuration relating to a method of fabricating a semiconductor device according to an embodiment

[Best Mode]

Advantages and features of the present invention, and methods for achieving them will become apparent with reference to embodiments or examples described below. However, the present invention is not limited to the embodiments or examples disclosed below, but may be implemented in various different forms. The embodiments or examples specified below are provided only to make the disclosure of the present invention complete and to inform those of ordinary skill in the technical field to which the present invention pertains of the scope of the invention, and the scope of rights of the present invention is defined by the scope of the claims.

In the drawings, when necessary, thicknesses of some components are enlarged to clearly express layers or regions. In addition, for convenience of explanation, thicknesses of some layers and regions in the drawings are exaggerated. Like reference numerals refer to like elements throughout the description.

In this description, when a portion such as a layer, a film, a region, or a plate is referred to as being "on", "over", or "above" another portion, it is construed to include not only a case where it is "directly on" another portion but also a case where another portion exists therebetween. When a portion is referred to as being "directly on" another portion, it is interpreted to mean that there is no other portion therebetween. In addition, when a portion such as a layer, a film, a region, or a plate is referred to as being "under", "below", or "beneath" another portion, it is construed to include not only a case where it is "directly under" another portion but also a case where another portion exists therebetween. When a portion is referred to as being "directly under" another portion, it is interpreted to mean that there is no other portion therebetween.

Hereinafter, embodiments according to the present invention will be described in detail.

In an embodiment, provided is a composition for a semiconductor process including silica particles and having a value of 6.30% to 9.60% according to Equation 1 below:

[Equation 1]

$$\frac{(L3+L5)}{L1} \times 100$$

In Equation 1, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

In another embodiment, a composition for a semiconductor process including silica particles and having a value of greater than 5.80% and less than 8.80% according to Equation 2 below:

[Equation 2]

$$\frac{(L3+L5)}{(L1+L3+L5)} \times 100$$

In Equation 2, L1 is a Liquid Particle Counting (LPC) value of particles having a particle diameter of greater than 1 um in the composition for a semiconductor process, L3 is an LPC value of particles having a particle diameter of greater

than 3 um in the composition for a semiconductor process, and L5 is an LPC value of particles having a particle diameter of greater than 5 um in the composition for a semiconductor process.

In an embodiment, the composition for a semiconductor process may simultaneously satisfy the respective ranges described above for Equation 1 and Equation 2.

A composition for a semiconductor process, more specifically, a composition for chemical mechanical polishing, may be applied to polish various films. Chemical mechanical polishing compositions for metal wiring, specifically, a composition for polishing a tungsten (W) film, typically require a low polishing rate in weak acidity. In addition, a stable tungsten surface corrosion degree by the composition is required, and it is essential to control a ratio of polishing rates, i.e., selectivity, for various film qualities exposed on a surface according to a pattern wafer manufacturing process. Generally, when silica ($SiO_2$) particles are used as abrasive particles in an acidic region, the silica particles have a negative (-) zeta-potential or a zeta-potential value, close to an Isoelectric Point (IEP), due to electrostatic characteristics of intrinsic surface functional groups (Si-O-H, Si-O-Si, Si-O-) of silica, so that the polishing rate of a silicon oxide ($SiO_2$) film is lowered, causing a problem that a polishing selectivity ratio of a tungsten (W) film to the silicon oxide ($SiO_2$) film becomes very low. To increase the polishing selectivity ratio of the tungsten (W) film to the silicon oxide ($SiO_2$) film, it is necessary to convert a zeta potential value into a positive (+) value by modifying surface functional groups of the silica particles in the composition for a semiconductor process, and effects vary not only in terms of a polishing rate or a polishing selectivity ratio but also stability aspects such as aggregation prevention, depending on various factors, such as a type of modifier, an input order of the modifier, a stirring speed and time, types and input orders of additives other than the modifier, and concentrations of the additives, in this surface modification process. The composition for a semiconductor process according to the embodiment of the present invention contains silica particles obtained through optimization of the surface modification process, so that there is almost no particle aggregation, and the zeta potential value is designed within an appropriate range, thereby exhibiting greatly improved technical advantages in terms of the polishing selectivity ratio and the stability of the composition.

These technical advantages of the composition for a semiconductor process may be implemented when the value of Equation 1 satisfies a predetermined range. Equation 1 includes, as components, a Liquid Particle Counting (LPC) value (L1) of particles having a particle diameter exceeding 1 um in the composition for a semiconductor process, an LPC value (L3) of particles having a particle diameter exceeding 3 um in the composition for a semiconductor process, and an LPC value (L5) of particles having a particle diameter exceeding 5 um in the composition for a semiconductor process. L1 is a value encompassing all particles counted for L3 and L5 as counting targets, and since a percentage value of a sum of L3 and L5 in the entire L1 corresponds to about 6.30% to about 9.60%, for example, about 6.50% to about 9.50%, for example, about 6.50% to about 9.00%, for example, about 6.50% to about 8.50%, for example, about 6.50% to about 8.00%, long-term stability wherein aggregation does not occur in the composition for a semiconductor process may be secured. At the same time, since Equation 1, which is a correlation of L1, L3, and L5, includes silica particles implementing particle characteristics satisfying the range, it may be more advantageous to implement a desired polishing selectivity ratio between a silicon oxide film and a tungsten film in a polishing process using the composition for a semiconductor process.

Meanwhile, the above-described technical advantages of the composition for a semiconductor process may be implemented by allowing the value of Equation 2 to satisfy predetermined ranges. Equation 2 includes, as components, a Liquid Particle Counting (LPC) value (L1) of particles having a particle diameter exceeding 1 um in the composition for a semiconductor process, an LPC value (L3) of particles having a particle diameter exceeding 3 um in the composition for a semiconductor process and an LPC value (L5) of particles having a particle diameter exceeding 5 um in the composition for a semiconductor process. L1 is a value encompassing all particles counted for L3 and L5 as counting targets, and since a percentage value of a sum of L3 and L5 with respect to a total sum of L1, L3, and L5 corresponds to greater than about 5.80%, less than about 8.80%, for example, about 6.00% to about 8.50%, for example, about 6.00% to about 8.00%, for example, about 6.00% to about 7.50%, for example, about 6.00% to about 7.40%, for example, about 6.00% to about 7.30%, for example, about 6.00% to about 7.20%, long-term stability wherein aggregation does not occur in the composition for a semiconductor process may be secured. At the same time, since Equation 2, which is a correlation of L1, L3, and L5, includes silica particles implementing particle characteristics satisfying the range, it may be more advantageous to implement a desired polishing selectivity ratio between a silicon oxide film and a tungsten film in a polishing process using the composition for a semiconductor process.

In an embodiment, when the value of Equation 1 satisfies the above-described range and, at the same time, the value of Equation 2 satisfies the above-described range, the composition for a semiconductor process may be more advantageous for securing both an aggregation prevention effect and an effect of implementing an appropriate polishing selectivity ratio.

In an embodiment, the composition for a semiconductor process may have a value of about 4.50 to about 10.00 according to Equation 3 below:

[Equation 3]

$$\frac{Rox}{(L1+L2+L3)}$$

In Equation 3, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, L5 is an LPC value of particles having a particle diameter greater than 5 um in the composition for a semiconductor process, and Rox is a polishing rate (Å/min) value of a silicon oxide film polished under conditions of a polishing pressure of 2 psi using the composition for a semiconductor process, a rotation speed of 120 rpm of a carrier mounted with a polishing target, a rotation speed of 120 rpm of a platen mounted with a polishing pad, and an injection rate of 300 ml/min of the composition for a semiconductor process.

The value of Equation 3 may be, for example, about 4.50 to about 10.00, for example, about 4.50 to about 9.50, for example, about 5.00 to about 10.00, for example, about 5.00 to about 9.50. Equation 3 is expressed as a dimensionless value representing a ratio of a polishing rate value for a silicon oxide film calculated in Å/min to a total sum of a Liquid Particle Counting (LPC) value (L1) of particles having a particle diameter exceeding 1 um in the composition for a semiconductor process, an LPC value (L3) of particles having a particle diameter exceeding 3 um in the composition for a semiconductor process and an LPC value (L5) of particles having a particle diameter exceeding 5 um in the composition for a semiconductor process. When adjusting LPC values for particles dispersed in the composition for a semiconductor process with a focus on aggregation prevention, a polishing rate for the silicon oxide film may deviate from a target range, for example, becoming excessively low. Therefore, by designing the composition for a semiconductor process such that the ratio of the polishing rate of the silicon oxide film to the total sum of L1, L3, and L5 satisfies the range, it may be more advantageous to secure an aggregation prevention effect and a desired polishing selectivity ratio.

Rox is a value having a Å/min unit, and may be, for example, about 1,390 to about 2,000, for example, about 1,400 to about 2,000, for example, about 1,500 to about 2,000, for example, about 1,550 to about 2,000, for example, about 1,600 to about 2,000, for example, about 1,700 to about 2,000, for example, about 1,800 to about 2,000, for example, about 1,850 to about 2,000.

L1 is an LPC value of particles having a particle diameter exceeding 1 um in the composition for a semiconductor process, and may be about 400 or less. L1 may be, for example, about 200 to about 400, for example, about 200 to about 350.

L3 is an LPC value of particles having a particle diameter exceeding 3 um in the composition for a semiconductor process, and may be about 20 or less. L3 may be, for example, about 10 to about 20, for example, about 10 to about 19, for example, about 10 to about 17.

In an embodiment, the composition for a semiconductor process may be more advantageous for maximizing the above-described technical advantages as at least two or more of Equations 1, 2 and 3 simultaneously satisfy the respective ranges.

The composition for a semiconductor process may include silica particles. The silica particle refers to a configuration of a particle shape in which silica ($SiO_2$) is a main component, and should be understood as a concept encompassing a case including a trace amount of a heterogeneous component. Here, 'trace amount' may mean a content at a level of about 0.005% by weight to about 0.03% by weight in 100% by weight of the entire silica particles.

The average particle diameter (D50) of the silica particles may be about 5 nm to about 150 nm, for example, about 5 nm to about 100 nm, for example, about 5 nm to about 80 nm, for example, about 10 nm to about 80 nm, for example, about 30 nm to about 50 nm, for example, about 35 nm to about 50 nm, for example, about 40 nm to about 50 nm, for example, about 42nm to about 48nm. By including silica particles having such a size, not only a chemical etching function but also a physical etching function of the composition for a semiconductor process may be appropriately secured, which may be more advantageous for the values of Equations 1, 2 and/or 3 to satisfy optimal ranges.

In the particle distribution of the silica particles, a 10% cumulative mass particle size distribution diameter (D10) may be, for example, about 5 nm to about 50 nm, for example, about 5 nm to about 35 nm, for example, about 10 nm to about 35 nm, for example, about 20 nm to about 35 nm, for example, about 23 nm to about 33 nm.

In the particle distribution of the silica particles, 80% cumulative mass particle size distribution diameter (D80) may be, for example, about 5 nm to about 60 nm, for example, about 10 nm to about 60 nm, for example, about 20 nm to about 60 nm, for example, about 25 nm to about 60 nm, for example, about 35 nm to about 60 nm, for example, about 40 nm to about 55 nm, for example, about 40 nm to about 50 nm.

In the particle distribution of the silica particles, 90% cumulative mass particle size distribution diameter (D90) may be, for example, about 10 nm to about 90 nm, for example, about 20 nm to about 80 nm, for example, about 30 nm to about 70 nm, for example, about 40 nm to about 60 nm, for example, about 45 nm to about 60 nm.

In the particle distribution of the silica particles, a ratio (D90/D10) of the 90% cumulative mass particle size distribution diameter (D90) to the 10% cumulative mass particle size distribution diameter (D10) may be about 1.90 to about 2.50, for example, about 1.95 to about 2.50, for example, about 2.00 to about 2.50, for example, about 1.90 to about 2.40, for example, about 1.90 to about 2.30, for example, about 1.95 to about 2.30.

In the particle distribution of the silica particles, a ratio (D90/D80) of the 90% cumulative mass particle size distribution diameter (D90) to the 80% cumulative mass particle size distribution diameter (D80) may be greater than about 1.00, less than about 1.80, for example, about 1.05 to about 1.70, for example, about 1.05 to about 1.60, for example, about 1.05 to about 1.50, for example, about 1.10 to about 1.40.

The silica particles in the composition for a semiconductor process may have a zeta potential of +20mV to +25mV, for example, about +22mV to +24mV. The zeta potential of the silica particles in the composition for a semiconductor process is not particularly limited, but for example, it may be measured after introducing about 1 mL of the composition for a semiconductor process into a measurement cell using a zeta potential measurement equipment (Malvern, Zeta-sizer Nano ZS). For example, the zeta potential value may be an average value of about 100 measurements. When the composition for a semiconductor process achieves Equation 1 and/or Equation 2 within the above-described ranges, respectively, and, at the same time, the zeta potential of the silica particles in the composition for a semiconductor process satisfies the above-described range, the composition for a semiconductor process may be more advantageous for securing an aggregation prevention effect and achieving a desired polishing selectivity ratio.

In an embodiment, a hydrogen ion concentration (pH) of the composition for a semiconductor process may be about 2 to about 5, for example, about 3 or more, about 5 or less, for example, about 3 or more, or less than about 5. When the hydrogen ion concentration (pH) of the composition for a semiconductor process satisfies the range and, at the same time, the zeta potential value of the silica particles in the composition for a semiconductor process satisfies the above-described range, polishing characteristics for a semiconductor wafer, which is a polishing target, may be optimally designed. Specifically, the silica particles should be adsorbed to a surface to be polished of the semiconductor wafer at a predetermined level or higher, and at the same time, should be easily separated at a predetermined level or higher. When the silica particles are adsorbed to the to-be-polished surface of the semiconductor wafer with excessive adsorption force and are not easily separated, defects such as scratches may be generated on the to-be-polished surface, and conversely, when the silica particles are not adsorbed to the to-be-polished surface due to an attraction force of a predetermined level or higher and have excessive fluidity, there is a concern that physical frictional force decreases and a polishing rate does not reach a target level. Considering this aspect, when the hydrogen ion concentration (pH) of the composition for a semiconductor process satisfies the above-described range and, at the same time, the zeta potential value of the silica particles in the composition for a semiconductor process satisfies the above-described range, the silica particles secure an appropriate level of adsorption to the to-be-polished surface of the semiconductor wafer and, at the same time, are easily separated from the to-be-polished surface, which may be advantageous for maximizing a defect prevention effect while securing a target level of polishing rate. These technical advantages may be further maximized when a surface to which the composition for a semiconductor process is applied includes a silicon oxide film.

In an embodiment, the silica particles may be included in an amount of about 0.5% by weight to about 5.0% by weight, for example, about 0.5% by weight to about 4.5% by weight, for example, about 0.5% by weight to about 4.0% by weight, for example, about 0.5% by weight to about 3.5% by weight, for example, about 1.0% by weight to about 5.0% by weight, for example, about 1.5% by weight to about 5.0% by weight, for example, about 2.0% by weight to about 5.0% by weight, for example, about 2.5% by weight to about 5.0% by weight, for example, about 1.0% by weight to about 4.5% by weight, for example, about 1.5% by weight to about 4.0% by weight, for example, about 2.0% by weight to about 4.0% by weight, for example, about 2.5% by weight to about 3.5% by weight, based on the total weight of the composition for a semiconductor process. When the silica particles are included in such a content, the composition for a semiconductor process may secure appropriate fluidity during the polishing process, and it may be more advantageous to achieve values of Equation 1, Equation 2, and/or Equation 3 in optimal ranges.

The composition for a semiconductor process may further include at least one additive, and the additive may include one selected from the group consisting of an azole-based compound, a fluorine-based compound, an alcohol compound, an organic acid, an inorganic acid, and a combination thereof. The additive may perform a role of adjusting a surface state of the polishing target to be suitable for deriving an optimal polishing result by performing a physical and/or chemical etching action together with the silica particles.

The azole-based compound may mainly perform a role of controlling surface characteristics of the tungsten (W) film. The azole-based compound may include, for example, one selected from the group consisting of imidazole, benzotriazole (BTA), 5-methyl-1H-benzotriazole (5-MBTA), 3-amino-1,2,4-triazole, 5-phenyl-1H-tetrazole, 3-amino-5-methyl-4H-1,2,4-triazole, 5-aminotetrazole (ATZ), 1,2,4-triazole, tolitriazole, and a combination thereof.

In an embodiment, the composition for a semiconductor process may include the azole-based compound in an amount of about 0.01 parts by weight to about 5.00 parts by weight, for example, about 0.01 parts by weight to about 4.50 parts by weight, for example, about 0.01 parts by weight to about 4.00 parts by weight, for example, about 0.01 parts by weight to about 3.50 parts by weight, for example, about 0.01 parts by weight to about 3.00 parts by weight, for example,

about 0.01 parts by weight to about 2.50 parts by weight, for example, about 0.01 parts by weight to about 2.00 parts by weight, for example, about 0.01 parts by weight to about 1.50 parts by weight, for example, about 0.05 parts by weight to about 5.00 parts by weight, for example, about 0.10 parts by weight to about 5.00 parts by weight, for example, about 0.20 parts by weight to about 5.00 parts by weight, for example, about 0.10 parts by weight to about 4.00 parts by weight, for example, about 0.20 parts by weight to about 3.00 parts by weight, for example, about 0.20 parts by weight to about 2.50 parts by weight, for example, about 0.20 parts by weight to about 2.00 parts by weight, for example, about 0.20 parts by weight to about 1.50 parts by weight, for example, greater than about 0.20 parts by weight, or about 1.50 parts by weight or less, based on 100 parts by weight of the abrasive particles.

The fluorine-based compound acts as a surfactant and may play a role in imparting appropriate fluidity to the silica particles. The fluorine-based compound may have a static surface tension of about 50 dynes/cm or less, for example, about 45 dynes/cm or less, for example, about 10 dynes/cm to about 50 dynes/cm, for example, about 10 dynes/cm to about 45 dynes/cm, in a 0.001% by weight aqueous solution state. The fluorine-based compound may have a static surface tension of about 30 dynes/cm or less, for example, about 25 dynes/cm or less, for example, about 5 dynes/cm to about 30 dynes/cm, for example, about 5 dynes/cm to about 25 dynes/cm, in a 0.01% by weight aqueous solution state. By applying the fluorine-based compound exhibiting such surface tension, fluidity of the composition for a semiconductor process may be appropriately secured, and it may be more advantageous to implement Equation 1, Equation 2, and/or Equation 3 within optimal ranges while preventing defects such as scratches on a to-be-polished surface. In addition, it may be advantageous in terms of maintaining the surface state of the silicon oxide film in a polishing-suitable state by using the fluorine-based compound, and may be advantageous in terms of improving long-term storage stability by preventing propagation of bacteria and fungi in the composition for a semiconductor process due to the fluorine component.

In an embodiment, the composition for a semiconductor process may include the fluorine-based compound in an amount of, for example, about 0.01 to about 1.00 parts by weight, for example, about 0.01 to about 0.80 parts by weight, for example, about 0.01 to about 0.70 parts by weight, for example, about 0.01 to about 0.60 parts by weight, for example, about 0.01 to about 0.50 parts by weight, for example, about 0.01 to about 0.40 parts by weight, for example, about 0.01 to about 0.30 parts by weight, for example, about 0.01 to about 0.20 parts by weight, for example, about 0.02 to about 1.00 parts by weight, for example, about 0.03 to about 1.00 parts by weight, for example, about 0.04 to about 1.00 parts by weight, for example, about 0.05 to about 1.00 parts by weight, for example, about 0.02 to about 0.50 parts by weight, for example, about 0.03 to about 0.40 parts by weight, for example, about 0.04 to about 0.30 parts by weight, for example, about 0.05 to about 0.30 parts by weight, for example, about 0.05 to about 0.20 parts by weight, based on 100 parts by weight of the silica particles.

The alcohol compound may play a role in assisting a smooth polishing action by being mainly attached onto a polishing surface of a polishing pad. The alcohol compound may include, for example, one selected from the group consisting of ethylene glycol, glycerol, erythritol, threitol, arabitol, xylitol, ribitol, mannitol, sorbitol, galactitol, fucitol, iditol, inositol, volemitol, isomalt, maltitol, lactitol, maltotriitol, maltotetraitol, polyglycitol, and a combination thereof.

In an embodiment, the alcohol compound may be included in an amount of about 50 parts by weight to about 80 parts by weight, for example, about 55 parts by weight to about 80 parts by weight, for example, about 60 parts by weight to about 80 parts by weight, for example, about 60 parts by weight to about 70 parts by weight, based on 100 parts by weight of the silica particles.

The organic acid may mainly perform a role of adjusting a hydrogen ion concentration (pH) of the composition for a semiconductor process. The organic acid may include, for example, one selected from the group consisting of acetic acid ($CH_3COOH$), formic acid, benzoic acid, nicotinic acid, picolinic acid, and a combination thereof.

In an embodiment, the organic acid may be included in an amount of about 0.50 parts by weight to about 10.00 parts by weight, for example, about 0.50 parts by weight to about 9.00 parts by weight, for example, about 0.50 parts by weight to about 8.00 parts by weight, for example, about 0.50 parts by weight to about 7.00 parts by weight, about 0.50 parts by weight to about 6.00 parts by weight, for example, about 0.50 parts by weight to about 5.00 parts by weight, for example, about 0.50 parts by weight to about 4.00 parts by weight, for example, about 0.50 parts by weight to about 3.50 parts by weight, for example, about 1.00 parts by weight to about 10.00 parts by weight, for example, about 1.00 parts by weight to about 10.00 parts by weight, for example, about 1.50 parts by weight to about 10.00 parts by weight, for example, about 1.00 parts by weight to about 8.00 parts by weight, for example, about 1.00 parts by weight to about 6.00 parts by weight, for example, about 1.50 parts by weight to about 5.00 parts by weight, for example, about 1.00 parts by weight to about 3.50 parts by weight, for example, about 1.50 parts by weight to about 3.50 parts by weight, for example, about 1.60 parts by weight to about 3.00 parts by weight, based on 100 parts by weight of the silica particles.

The inorganic acid may mainly perform a role of adjusting the hydrogen ion concentration (pH) of the composition for a semiconductor process. The inorganic acid may include, for example, one selected from the group consisting of hydrochloric acid (HCl), phosphoric acid ($H_3PO_4$), sulfuric acid ($H_2SO_4$), nitric acid ($HNO_3$), boric acid ($H_3BO_3$), carbonic acid ($H_2CO_3$), hydrofluoric acid (HF), hydrobromic acid (HBr), perchloric acid ($HClO_4$), hydroiodic acid (HI), and a combination thereof. More specifically, the inorganic acid may include one selected from the group consisting of phosphoric acid ($H_3PO_4$), nitric acid ($HNO_3$), and a combination thereof. When this type of inorganic acid is applied, it

may be easy to adjust pH and the effect of preventing aggregation may be excellent, so it may be more advantageous for the composition for a semiconductor process to achieve Equation 1, Equation 2, and/or Equation 3 in optimal ranges.

In an embodiment, the inorganic acid may be included in an amount of about 0.01 to about 1.00 parts by weight, for example, about 0.01 parts by weight to about 0.80 parts by weight, for example, about 0.01 parts by weight to about 0.50 parts by weight, for example, about 0.01 parts by weight to about 0.40 parts by weight, about 0.01 parts by weight to about 0.30 parts by weight, for example, about 0.01 parts by weight to about 0.20 parts by weight, based on 100 parts by weight of the silica particles.

The composition for a semiconductor process may include a remaining content of a solvent other than the silica particles and the additive. The solvent may be, for example, water ($H_2O$), and specifically, ultrapure water.

The composition for a semiconductor process may have a solid content of about 3.5% by weight to about 20% by weight, for example, about 3.5% by weight to about 15% by weight, for example, about 3.5% by weight to about 10% by weight, for example, about 3.5% by weight to about 8.0% by weight. When the solid content is excessively small, there is a concern that a polishing rate for each film quality of the polishing target is not sufficiently secured, and when the solid content is excessively large, there is a concern that defects such as scratches may occur during the polishing process due to unnecessary aggregation. As the composition for a semiconductor process includes the silica particles, the additive, and the solvent and, thus, satisfies the above solid content range, it may be more advantageous to inject at a uniform flow rate when applied to a polishing process, and it may be more advantageous in terms of securing uniform dispersibility and storage stability during distribution and storage processes of the composition for a semiconductor process.

In another embodiment, there is provided a method of preparing a composition for a semiconductor process including: step (a) of stirring an aqueous silica dispersion solution having a hydrogen ion concentration (pH) in a range of 4.0 to 5.5; step (b) of introducing a silica surface modifier containing an aminosilane component when a temperature of the aqueous silica dispersion solution is in a range of 25°C or higher and lower than 40°C; step (c) of introducing a hydrogen ion concentration (pH) adjuster into the aqueous silica dispersion solution into which the silica surface modifier has been introduced; and step (d) of stirring the aqueous silica dispersion solution, into which the hydrogen ion concentration (pH) adjuster has been introduced, such that a final reaction temperature reaches one in a range of 50°C to 65°C.

In the method of preparing a composition for a semiconductor process, descriptions modifying steps such as '(a)', '(b)', etc. are merely described for convenience in explaining respective steps, and a chronological order is not limited by the alphabetical order of such descriptions unless the chronological order is determined by a specific configuration.

The method of preparing a composition for a semiconductor process is a preparation method specialized for preparing a composition for a semiconductor process having the above-described technical advantages and effects, and the composition for a semiconductor process produced by the preparation method may exhibit all of the features described above in relation to Equations 1, 2, and 3. Furthermore, all matters described above regarding the composition for a semiconductor process may be equally integrated and applied to the composition for a semiconductor process produced by the preparation method, not only when repeatedly described below but also when not repeatedly described below.

The composition for a semiconductor process produced by the method of preparing a composition for a semiconductor process may include silica particles and may have a value of about 6.30% to about 9.60%, for example, about 6.50% to about 9.50%, for example, about 6.50% to about 9.00%, for example, about 6.50% to about 8.50%, for example, about 6.50% to about 8.00% according to Equation 1 below:

[Equation 1]

$$\frac{(L3+L5)}{L1} \times 100$$

In Equation 1, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

The composition for a semiconductor process produced by the method of preparing a composition for a semiconductor process may have a value of greater than about 5.80%, less than about 8.80%, for example, about 6.00% to about 8.50%, for example, about 6.00% to about 8.00%, for example, about 6.00% to about 7.50%, for example, about 6.00% to about 7.40%, for example, about 6.00% to about 7.30%, for example, about 6.00% to about 7.20% according to Equation 2 below:

[Equation 2]

$$\frac{(L3+L5)}{(L1+L3+L5)} \times 100$$

In Equation 2, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

The composition for a semiconductor process produced by the method of preparing a composition for a semiconductor process may have a value of about 4.50 to about 10.00, for example, about 4.50 to about 9.50, for example, about 5.00 to about 10.00, for example, about 5.00 to about 9.50 according to Equation 3 below:

[Equation 3]

$$\frac{Rox}{(L1+L2+L3)}$$

In Equation 3, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, L5 is an LPC value of particles having a particle diameter greater than 5 um in the composition for a semiconductor process, and Rox is a polishing rate (Å/min) value of a silicon oxide film polished under conditions of a polishing pressure of 2 psi using the composition for a semiconductor process, a rotation speed of 120 rpm of a carrier mounted with a polishing target, a rotation speed of 120 rpm of a platen mounted with a polishing pad, and an injection rate of 300 ml/min of the composition for a semiconductor process.

The method of preparing a composition for a semiconductor process includes step (a) of stirring an aqueous silica dispersion solution having a hydrogen ion concentration (pH) in a range of 4.0 to 5.5. In step (a), a pH of the aqueous silica dispersion solution may be about 4.0 to about 5.5, for example, about 4.5 to about 5.5. When the pH of the aqueous silica dispersion solution satisfies such a range, raw silica particles in the aqueous silica dispersion solution have a negative (-) zeta potential value. At this time, the zeta potential of the raw silica particles in the aqueous silica dispersion solution may be, for example, about -15 mV to about -30 mV, or, for example, about -20 mV to about -30 mV. When raw silica particles having such a negative (-) zeta potential are applied directly to a composition for a semiconductor process, they are not adsorbed to a silicon oxide film with an attraction force of a predetermined level or higher and have excessive fluidity, so there is a concern that a polishing rate may not reach a target level. In addition, a possibility that particles are excessively aggregated may increase. The method of preparing a composition for a semiconductor process may be applied to a composition for a semiconductor process while effectively preventing the above-described technical problems by processing the aqueous silica dispersion solution having the pH within the range through various steps described below. That is, by applying the aqueous silica dispersion solution having the pH within the range as a raw material, technical advantages of the composition for a semiconductor process prepared by the method of preparing a composition for a semiconductor process may be maximized.

In step (a), the aqueous silica dispersion solution may be stirred at a speed of about 500 rpm to about 3000 rpm, for example, about 800 rpm to about 3000 rpm, for example, about 1000 rpm to about 3000 rpm, for example, about 1200 rpm to about 3000 rpm, for example, about 1400 rpm to about 3000 rpm, for example, about 1500 rpm to about 3000 rpm, for example, about 500 rpm to about 2800 rpm, for example, about 500 rpm to about 2600 rpm, for example, about 500 rpm to about 2400 rpm, for example, about 500 rpm to about 2000 rpm, for example, about 500 rpm to about 1800 rpm, for example, about 800 rpm to about 2800 rpm, for example, about 1000 rpm to about 2600 rpm, for example, about 1200 rpm to about 2400 rpm, for example, about 1400 rpm to about 2000 rpm, for example, about 1500 rpm to about 1800 rpm. While the aqueous silica dispersion solution is stirred, heat is generated due to friction of the raw silica particles, and by stirring the aqueous silica dispersion solution at the stirring speed within the range, it may be more advantageous for the frictional heat generated by the raw silica particles to correspond a reaction temperature suitable for modifying surfaces of the raw silica particles to a target level. The surface modification of the raw silica particles needs to be achieved to a target level so that a

composition for a semiconductor process in which Equation 1, Equation 2, and/or Equation 3 satisfy optimal ranges may be prepared, and accordingly, a polishing selectivity ratio of the silicon oxide film relative to tungsten (W) may implement a target range, and at the same time, an aggregation prevention effect of the silica particles in the composition for a semiconductor process may be maximized.

The aqueous silica dispersion solution is an aqueous solution in which the raw silica particles are dispersed in a colloidal state, and the content of the raw silica particles in the aqueous silica dispersion solution may be about 20% by weight to about 40% by weight, for example, about 25% by weight to about 40% by weight, for example, about 20% by weight to about 35% by weight, for example, about 20% by weight to about 30% by weight, or, for example, about 25% by weight to about 30% by weight. As described above, frictional heat between the raw material silica particles is generated in the process of stirring the aqueous silica dispersion solution, and when the aqueous silica dispersion solution contains the raw material silica particles in such a content, a technical advantage may be obtained in that the frictional heat generated by stirring is generated in an amount corresponding to a reaction temperature advantageous for surface-modifying the raw material silica particles to a target level.

The method of preparing a composition for a semiconductor process includes step (b) of introducing a silica surface modifier containing an aminosilane component when the temperature of the aqueous silica dispersion solution is in a range of 25°C or higher or lower than 40°C. When the aqueous silica dispersion solution is stirred in step (a), a reaction temperature increases due to frictional heat of the raw silica particles in the aqueous silica dispersion solution. When the temperature of the aqueous silica dispersion solution corresponds to any one of, for example, about 25°C or higher and lower than about 40°C, or, for example, about 30°C or higher and lower than about 40°C, the surface of the raw material silica particles may be modified to a target level by introducing the silica surface modifier, and accordingly, it may be more advantageous for the composition for a semiconductor process to implement Equation 1, Equation 2, and/or Equation 3 within optimal ranges. When the temperature of the aqueous silica dispersion solution at the time of introducing the silica surface modifier is excessively low or high, a degree of surface modification of the raw material silica particles is not appropriate, so there is a concern that excessive aggregation may occur, and in that case, there is a concern that a problem may arise in that Equation 1, Equation 2, and/or Equation 3 are not implemented within optimal ranges, leading to defects and failure to implement the polishing selectivity ratio within a target range.

The silica surface modifier includes aminosilane. The aminosilane may have a structure of Formula 1 below:

[Formula 1]

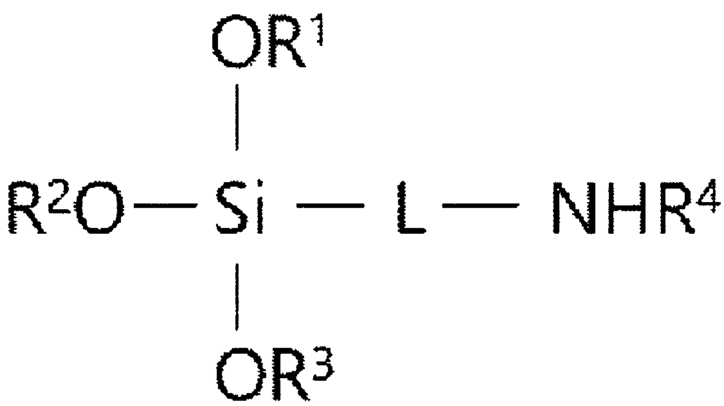

In Formula 1, $R^1$, $R^2$, and $R^3$ may be each independently one selected from hydrogen, a methyl group, an ethyl group, and a propyl group; $R^4$ may be one selected from hydrogen, an alkyl group having 1 to 10 carbon atoms, and an aminoalkyl group having 1 to 10 carbon atoms; and L may be one selected from alkylene groups having 1 to 5 carbon atoms. $R^4$ may be, for example, one selected from hydrogen, a methyl group, an ethyl group, a propyl group, a butyl group, a pentyl group, a hexyl group, an aminoethyl group, and an aminopropyl group. L may be, for example, one selected from a methylene group, an ethylene group, a propylene group, and a butylene group. In an embodiment, $R^4$ may be one selected from hydrogen and an aminoethyl group, and L may be a propylene group.

As the silica surface modifier includes the aminosilane having such a chemical structure, the silica particles modified therefrom may satisfy appropriate dispersibility within the composition for a semiconductor process, and it may be more advantageous for the zeta potential in the composition for a semiconductor process to implement a target range. As a result, Equation 1, Equation 2, and/or Equation 3 may achieve optimal ranges, and thus, the composition for a semiconductor process may be more advantageous for simultaneously securing an aggregation prevention effect and achieving a desired polishing selectivity ratio.

The silica surface modifier may be added in an amount of about 0.05 parts by weight to about 0.50 parts by weight, for example, about 0.05 parts by weight to about 0.45 parts by weight, for example, about 0.05 parts by weight to about 0.40 parts by weight, for example, about 0.05 parts by weight to about 0.35 parts by weight, for example, about 0.05 to about 0.30 parts by weight, for example, about 0.10 parts by weight to about 0.50 parts by weight, for example, about 0.15 parts by weight to about 0.50 parts by weight, for example, about 0.10 parts by weight to about 0.40 parts by weight, for example, about 0.15 parts by weight to about 0.30 parts by weight, based on 100 parts by weight of the raw silica particles.

The method of preparing a composition for a semiconductor process includes step (c) of introducing a hydrogen ion concentration (pH) adjuster into the aqueous silica dispersion solution into which the silica surface modifier has been introduced. The method of preparing a composition for a semiconductor process may maximize an aggregation prevention effect by sequentially performing step (b) and step (c). Specifically, by introducing the silica surface modifier first and introducing the pH adjuster later in the preparation process of the composition for a semiconductor process, it may be advantageous for implementing the aggregation prevention effect of particles in the composition for a semiconductor process to a target level, compared to a case where they are introduced simultaneously or the pH adjuster is introduced prior to the silica surface modifier. More specifically, when the silica surface modifier and the pH adjuster are introduced simultaneously, or the pH adjuster is introduced prior to the silica surface modifier, Equation 1, Equation 2, and/or Equation 3 do not satisfy appropriate ranges, which may mean that a ratio of particles enlarged by aggregation among total particles increases, so that the aggregation prevention effect is not achieved to a target level.

The hydrogen ion concentration (pH) adjuster may include, for example, one selected from the group consisting of an organic acid, an inorganic acid, and a combination thereof. Specifically, the organic acid may include, for example, one selected from the group consisting of acetic acid ($CH_3COOH$), formic acid, benzoic acid, nicotinic acid, picolinic acid, and a combination thereof. The inorganic acid may include, for example, one selected from the group consisting of hydrochloric acid (HCl), phosphoric acid ($H_3PO_4$), sulfuric acid ($H_2SO_4$), nitric acid ($HNO_3$), boric acid ($H_3BO_3$), carbonic acid ($H_2CO_3$), hydrofluoric acid (HF), hydrobromic acid (HBr), perchloric acid ($HClO_4$), hydroiodic acid (HI), and a combination thereof.

In an embodiment, the hydrogen ion concentration (pH) adjuster may include an acid component including one selected from the group consisting of the organic acid, the inorganic acid, and a combination thereof, and a solvent. The solvent may include, for example, water ($H_2O$). Specifically, a weight ratio of the acid component to the solvent may be about 1:1 to about 1:15, for example, about 1:2 to about 1:15, for example, about 1:3 to about 1:15, for example, about 1:5 to about 1:15, for example, about 1:7 to about 1:13, or, for example, about 1:8 to about 1:12. As the acid component is diluted to such a level by the solvent, it may be more advantageous for maximizing the aggregation prevention effect of particles in the composition for a semiconductor process while sufficiently securing the intrinsic function of the pH adjuster.

In an embodiment, a weight ratio of the silica surface modifier to the hydrogen ion concentration (pH) adjuster may be about 1:1 to about 5:1, for example, about 1:1 to about 4:1, or, for example, about 1:1 to about 3:1. By adjusting the weight ratio of the silica surface modifier to the pH adjuster to such a range, surface modification of the raw silica particles may be achieved to a target level, a surface zeta potential may be implemented within a target range, and it may be more advantageous for increasing the aggregation prevention effect of the composition for a semiconductor process.

In step (c), the hydrogen ion concentration (pH) adjuster may be introduced at a rate of, for example, about 1 L/min to about 10 L/min, for example, about 1 L/min to about 9 L/min, for example, about 1 L/min to about 8 L/min, for example, about 1 L/min to about 7 L/min, for example, about 1 L/min to about 6 L/min, for example, about 2 L/min to about 10 L/min, for example, about 3 L/min to about 10 L/min, for example, about 4 L/min to about 10 L/min, for example, about 2 L/min to about 9 L/min, for example, about 3 L/min to about 8 L/min, for example, about 4 L/min to about 7 L/min.

The method of preparing a composition for a semiconductor process includes step (d) of stirring the aqueous silica dispersion solution into which the hydrogen ion concentration (pH) adjuster has been introduced.

In step (d), a final reaction temperature of the aqueous silica dispersion solution may be about 50°C to about 65°C, for example, about 52°C to about 65°C, for example, about 54°C to about 65°C, for example, about 56°C to about 65°C, for example, about 58°C to about 65°C, for example, about 50°C to about 64°C, for example, about 50°C to about 63°C, for example, about 50°C to about 62°C, for example, about 52°C to about 63°C, for example, about 56°C to about 63°C, for example, about 58°C to about 62°C. The 'final reaction temperature' of the aqueous silica dispersion solution refers to a temperature at a time point when stirring of the aqueous silica dispersion solution is completed through step (d). As the final reaction temperature of the aqueous silica dispersion solution is achieved within the range, particle aggregation may be effectively prevented. More specifically, when the temperature of the aqueous silica dispersion solution at the time of introducing the silica surface modifier in step (b) satisfies the above-described range, and simultaneously, the final reaction temperature of the aqueous silica dispersion solution in step (d) satisfies the range, it may be more advantageous for Equation 1, Equation 2, and/or Equation 3 to achieve optimal ranges, and it may be more advantageous for simultaneously securing a particle aggregation prevention effect and achieving a desired polishing selectivity ratio.

Step (d) may be performed for, for example, about 2 hours to about 10 hours, or, for example, about 4 hours to about 8 hours. In step (d), the aqueous silica dispersion solution may be stirred at a speed of about 1000 rpm to about 2500

rpm, for example, about 1100 rpm to about 2400 rpm, for example, about 1200 rpm to about 2300 rpm, for example, about 1300 rpm to about 2200 rpm, for example, about 1400 rpm to about 2100 rpm, for example, about 1500 rpm to about 2000 rpm, for example, about 1600 rpm to about 1900 rpm, for example, about 1700 rpm to about 1800 rpm. As the stirring speed and time of the aqueous silica dispersion solution satisfy such ranges, it may be easier to achieve the final reaction temperature of step (d) within the above-described range, and as a result, it may be more advantageous for simultaneously securing a particle aggregation prevention effect and achieving a desired polishing selectivity ratio.

An LPC value of particles having a particle diameter exceeding 1 um in the aqueous silica dispersion solution at a time point when step (d) is completed may be less than about 10,000, for example, about 500 or more, less than about 10,000, for example, about 500 to about 8,000, for example, about 500 to about 5,000, for example, about 500 to about 3,000.

An LPC value of particles having a particle diameter exceeding 3 um in the aqueous silica dispersion solution at a time point when step (d) is completed may be less than about 1,500, for example, about 100 or more, less than about 1,500, for example, about 100 to about 1,000, for example, about 100 to about 400, for example, about 100 to about 350, for example, about 100 to about 300.

An LPC value of particles having a particle diameter exceeding 5 um in the aqueous silica dispersion solution at a time point when step (d) is completed may be less than about 500, for example, about 10 or more, less than about 500, for example, about 10 to about 400, for example, about 10 to about 300, for example, about 10 to about 200, for example, about 10 to about 150, for example, about 10 to about 100.

As each of the LPC values of particles having particle diameters exceeding 1 um, exceeding 3 um, and exceeding 5 um in the aqueous silica dispersion solution at the time point when step (d) is completed satisfies the above-described ranges, it may be more advantageous for values of Equations 1, 2, and/or 3 of the composition for a semiconductor process prepared through this process to achieve optimal ranges.

When a zeta potential value of raw silica particles in the aqueous silica dispersion solution immediately before step (b) is defined as ZP1, a zeta potential value of raw silica particles in the aqueous silica dispersion solution immediately before step (c) is defined as ZP2, and a zeta potential value of silica particles in the final composition for a semiconductor process is defined as ZP3, a value of Equation 4 below may be greater than about 9.60 and less than about 17.00, or, for example, about 10.00 to about 16.00. In steps (b), (c), and (d), the value of Equation 4 below may be designed within an optimal range by appropriately setting temperature conditions and appropriately setting concentration conditions of the pH adjuster. As a result, the polishing selectivity ratio of the composition for a semiconductor process may be implemented within an optimal range, and it may be more advantageous to secure the aggregation prevention effect during the preparation process of the composition for a semiconductor process.

[Equation 4]

$$\frac{(ZP2\text{-}ZP1)}{(ZP2\text{-}ZP3)}$$

The zeta potential (mV) value (ZP1) of the raw silica particles in the aqueous silica dispersion solution immediately before step (b) may be about -30 to about -50, or, for example, about -30 to about -40.

In an embodiment, the zeta potential (mV) value (ZP3) of the silica particles in the final composition for a semiconductor process may be about 10 to about 40, for example, about 15 to about 40, for example, about 20 to about 35, or, for example, about 25 to about 30.

In another embodiment, there is provided a method of manufacturing a semiconductor device, the method including: a step of disposing a to-be-polished surface of a polishing target to be in contact with a polishing surface of a polishing pad; a step of injecting a composition for a semiconductor process onto the polishing surface; and polishing the to-be-polished surface while rotating the polishing pad and the polishing target relative to each other, wherein the composition for a semiconductor process has a value of 6.30% to 9.60% according to Equation 1 below:

[Equation 1]

$$\frac{(L3+L5)}{L1} \times 100$$

In Equation 1, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

In still another embodiment, provided is a method of manufacturing a semiconductor device, the method including: a step of disposing a to-be-polished surface of a polishing target to be in contact with a polishing surface of a polishing pad; a step of injecting a composition for a semiconductor process onto the polishing surface; and a step of polishing the to-be-polished surface while rotating the polishing pad and the polishing target relative to each other, wherein the composition for a semiconductor process has a value of greater than 5.80% or less than 8.80% according to Equation 2 below:

[Equation 2]

$$\frac{(L3+L5)}{(L1+L3+L5)} \times 100$$

In Equation 2, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, and L5 is an LPC value of particles having a particle diameter of greater than 5 um in the composition for a semiconductor process.

In the method of manufacturing a semiconductor device, by applying the composition for a semiconductor process in which the value of Equation 1 or 2 satisfies a predetermined range when a semiconductor wafer having a structure requiring simultaneous polishing of a tungsten (W) film and a silicon oxide film is used as a polishing target, a polishing selectivity ratio of the silicon oxide film relative to the tungsten film may be implemented within an optimal range, and a semiconductor device of improved quality may be manufactured without defects such as scratches derived from aggregates or impurities in the composition for a semiconductor process during the polishing process.

In the method of manufacturing a semiconductor device, it may be advantageous for maximizing the technical advantages as Equations 1 and 2 of the composition for a semiconductor process simultaneously satisfy the above-described ranges, respectively.

In an embodiment, the composition for a semiconductor process may have a value of, for example, about 4.50 to about 10.00, for example, about 4.50 to about 9.50, for example, about 5.00 to about 10.00, for example, about 5.00 to about 9.50 according to Equation 3 below:

[Equation 3]

$$\frac{Rox}{(L1+L2+L3)}$$

In Equation 3, L1 is a Liquid Particle Counting (LPC) value of particles having a particle diameter of greater than 1 um in the composition for a semiconductor process, L3 is an LPC value of particles having a particle diameter of greater than 3 um in the composition for a semiconductor process, L5 is an LPC value of particles having a particle diameter greater than 5 um in the composition for a semiconductor process, and Rox is a polishing rate (Å/min) value of a silicon oxide film polished under conditions of a polishing pressure of 2 psi using the composition for a semiconductor process, a rotation speed of 120 rpm of a carrier mounted with a polishing target, a rotation speed of 120 rpm of a platen mounted with a

polishing pad, and an injection rate of 300 ml/min of the composition for a semiconductor process.

Matters regarding the composition for a semiconductor process applied to the method of manufacturing a semiconductor device may be interpreted as being integrated and applied equally to all matters described above regarding the composition for a semiconductor process according to an embodiment, not only when repeatedly described below but also when not repeatedly described below.

FIG. 1 schematically illustrates an apparatus configuration relating to a method of manufacturing a semiconductor device according to an embodiment. Referring to FIG. 1, the method of manufacturing a semiconductor device includes a step of disposing a to-be-polished surface of a polishing target 130 to be in contact with a polishing surface 111 of a polishing pad 110; and injecting a composition 150 for a semiconductor process onto the polishing surface 111.

The polishing target 130 may include a semiconductor wafer having a tungsten (W) film and a silicon oxide film. Specifically, the to-be-polished surface may include a surface requiring simultaneous polishing of the tungsten film and the silicon oxide film. Since the polishing target 130 and the to-be-polished surface thereof have these characteristics, it may be advantageous for maximizing technical advantages obtained by the values of Equations 1, 2, and/or 3 of the composition for a semiconductor process satisfying the predetermined ranges.

A surface hardness of the polishing pad 110 measured on the polishing surface 111 is a Shore D hardness, and the Shore D hardness may be about 50 to about 70, for example, about 50 to about 65, or, for example, about 55 to about 65. Methods commonly used in the art may be broadly applied to measure the Shore D surface hardness on the polishing surface. For example, it may be measured using a hardness tester (D-type hardness tester) after preparing a sample obtained by cutting the polishing pad into a size of 2 cm $\times$ 2 cm (thickness: 2 mm) and allowing it to stand for 16 hours in an environment of a temperature of 25°C and a humidity of 50$\pm$5%. As the hardness on the polishing surface 111 satisfies such a range, it may exhibit a physically appropriate elastic correlation with the polishing pad 110 while the composition for a semiconductor process 150 flows at a contact interface between the polishing surface 111 and the to-be-polished surface of the polishing target 130, and as a result, it may be more advantageous for a semiconductor device manufactured by the method of manufacturing a semiconductor device to exhibit high polishing flatness without defects such as scratches.

Grooves may be formed on the polishing surface 111 of the polishing pad 110. The grooves are configured to control fluidity of the composition for a semiconductor process 150 injected onto the polishing surface 111. A shape of the grooves is not particularly limited, but a depth thereof may be, for example, about 300 $\mu$m to about 900 $\mu$m, for example, about 300 $\mu$m to about 850 $\mu$m, for example, about 400 $\mu$m to about 850 $\mu$m, for example, about 450 $\mu$m to about 850 $\mu$m, for example, about 500 $\mu$m to about 800 $\mu$m, for example, about 550 $\mu$m to about 800 $\mu$m, or, for example, about 600 $\mu$m to about 800 $\mu$m. In addition, a width of the grooves may be about 100 $\mu$m to about 600 $\mu$m, for example, about 200 $\mu$m to about 600 $\mu$m, for example, about 200 $\mu$m to about 550 $\mu$m, for example, about 300 $\mu$m to about 550 $\mu$m, or, for example, about 350 $\mu$m to about 550 $\mu$m. When the depth and width of the grooves satisfy such ranges, it may be more advantageous to impart optimized fluidity to the composition for a semiconductor process in which Equation 1, Equation 2, and/or Equation 3 satisfy the above-described ranges, respectively.

The case that the to-be-polished surface of the polishing target 130 is in contact with the polishing surface 111 of the polishing pad 110 may be interpreted to include not only a case of direct physical contact with each other but also a case of indirect contact with each other via the composition for a semiconductor process.

The step of injecting the composition for a semiconductor process 150 onto the polishing surface 111 may be specifically performed by a method in which the composition for a semiconductor process 150 is injected onto the polishing surface 111 through a supply nozzle 140. In an embodiment, a flow rate of the composition for a semiconductor process 150 injected through the supply nozzle 140 may be about 10 mL/min to about 1,000 mL/min, for example, about 10 mL/min to about 800 mL/min, for example, about 50 mL/min to about 500 mL/min, for example, about 80 mL/min to about 400 mL/min, for example, about 100 mL/min to about 300 mL/min, for example, about 150 mL/min to about 300 mL/min. When the composition 150 for a semiconductor process satisfying Equation 1, Equation 2, and/or Equation 3 in the above-described ranges, respectively, is injected onto the polishing surface 111 at a flow rate in such a range, friction behavior between the polishing surface 111 and the to-be-polished surface via this may be more advantageous for improving polishing performance of the to-be-polished surface. More specifically, it may be more advantageous for achieving a desired polishing selectivity ratio and simultaneously implementing a defect prevention effect such as prevention of scratches caused by solids in the composition for a semiconductor process.

The composition for a semiconductor process may include silica particles and at least one type of additive. Matters regarding the silica particles and the additive may be interpreted as being integrated and applied equally to all matters described above regarding the composition for a semiconductor process. That is, all specific examples and technical advantages thereof for the silica particles and the additive, described above regarding the composition for a semiconductor process, may be interpreted as being integrated and applied to the composition for a semiconductor process applied to the method of manufacturing a semiconductor device, and may achieve advantageous interactions in terms of achieving technical objectives in relation to other configurations, for example, structure and driving of the polishing pad, of the method of manufacturing a semiconductor device.

The method of manufacturing a semiconductor device includes a step of polishing the to-be-polished surface

while rotating the polishing pad 110 and the polishing target 130 relative to each other. Referring to FIG. 1, the polishing pad 110 may be mounted on a platen 120 such that the polishing surface 111 reaches the uppermost surface, and the polishing target 130 may be accommodated in a carrier 160 such that the to-be-polished surface becomes the lowermost surface. The polishing pad 110 and the polishing target 130 may respectively rotate at the same speed and trajectory as the platen 120 and the carrier 160 rotate. Rotating the polishing pad 110 and the polishing target 130 relative to each other means rotating them in a state where the polishing surface and the to-be-polished surface are disposed to be in contact. A rotation direction of the polishing pad 110 and a rotation direction of the polishing target 130 may be opposite to each other or may be the same.

In an embodiment, rotation speeds of the polishing pad 110 and the polishing target 130 may be each independently about 10 rpm to about 500 rpm, or, for example, about 30 rpm to about 200 rpm. When the polishing pad 110 and the polishing target 130 rotate at rotation speeds within the ranges, respectively, friction behavior between the polishing surface 111 and the to-be-polished surface due to centrifugal force thereof is interconnected with the composition for a semiconductor process 150 injected onto the polishing surface 111, so that the to-be-polished surface may be polished to have high polishing flatness, and it may be more advantageous for polishing the surface without defects.

In an embodiment, a rotation speed of the polishing target 130 may be greater than a rotation speed of the polishing pad 110. By rotating the polishing target 130 at a higher speed than the polishing pad 110, it may be more advantageous for securing polishing stability and simultaneously polishing the to-be-polished surface of the polishing target 130 without defects.

In an embodiment, the method of manufacturing a semiconductor device may rotate the polishing pad 110 and the polishing target 130 relative to each other under a condition where the to-be-polished surface is pressed against the polishing surface 111. As the to-be-polished surface is pressed against the polishing surface 111 and simultaneously subjected to rotational friction, it may be more advantageous for maximizing technical advantages obtained by physical and/or chemical polishing behaviors with the composition 150 injected onto the polishing surface 111, provided that the values of Equation 1, Equation 2, and/or Equation 3 satisfy predetermined ranges. A load with which the to-be-polished surface is pressed against the polishing surface 111 may be, for example, about 0.01 psi to about 20 psi, or, for example, about 0.1 psi to about 15 psi.

The method of manufacturing a semiconductor device may further include a step of processing the polishing surface 111 using a conditioner 170. The polishing surface 111 of the polishing pad 110 is chemically affected as the composition for a semiconductor process 150 is continuously supplied, and at the same time, is physically affected due to physical contact with the to-be-polished surface of the polishing target 130. When a state of the polishing surface 111 is deformed due to such chemical/physical influences, it may be difficult to uniformly maintain polishing performance for the to-be-polished surface. The conditioner 170 serves as a means for processing the polishing surface 111 during the polishing process, and may contribute to uniformly maintaining the polishing surface 111 in a state suitable for polishing throughout the polishing process.

For example, the conditioner 170 may perform a role of roughening the polishing surface 111 while rotating at a predetermined speed. A rotation speed of the conditioner 170 may be, for example, about 10 rpm to about 500 rpm, for example, about 50 rpm to about 500 rpm, for example, about 100 rpm to about 500 rpm, for example, about 200 rpm to about 500 rpm, for example, greater than about 200 rpm, or less than about 400 rpm.

The conditioner 170 may rotate while being pressed against the polishing surface 111 of the polishing pad 110 with a predetermined pressure. For example, a pressing pressure of the conditioner 170 against the polishing surface 111 may be about 1 psi to about 20 psi, for example, about 1 psi to about 15 psi, for example, about 5 psi to about 15 psi, or, for example, about 5 psi to about 10 psi.

By performing surface treatment under the above-described process conditions using the conditioner 170, the polishing surface 111 may maintain an optimal surface state throughout the polishing process, and an effect of prolonging polishing lifespan under application conditions of the composition 150 for a semiconductor process may be obtained.

Hereinafter, specific examples of the present invention are presented. However, the examples described below are provided merely for specifically illustrating or explaining the present invention, and the scope of rights of the present invention should not be construed as being limited thereby, but is determined by the scope of the claims.

## <Examples and comparative examples>

### Example 1

An aqueous silica dispersion solution having a hydrogen ion concentration (pH) of 4.9 (±0.4) was prepared. This was stirred at a speed of 1675 (±75) rpm. When the temperature of the aqueous silica dispersion solution reached 35°C, 0.1 parts by weight of a silica surface modifier was introduced based on 100 parts by weight of the raw silica particles in the aqueous silica dispersion solution. 3-aminopropyltriethoxysilane was used as the silica surface modifier. Meanwhile, a hydrogen ion concentration (pH) adjuster having a weight ratio of nitric acid ($HNO_3$) to water ($H_2O$) of 1:10 was prepared,

and the hydrogen ion concentration (pH) adjuster was introduced into the aqueous silica dispersion solution into which the silica surface modifier had been introduced. Here, a weight ratio of the silica surface modifier to the hydrogen ion concentration (pH) adjuster was adjusted to be 1:1. The aqueous silica dispersion solution into which the hydrogen ion concentration (pH) adjuster had been introduced was stirred for about 6 hours, and the stirring was terminated when a final reaction temperature reached 60 (±2)°C. Sorbitol, imidazole, acetic acid, and a fluorine-based compound (HS-31ET, Unichem Co.) were mixed with the silica particles in the aqueous silica dispersion solution, such that they were mixed to satisfy parts by weight shown in Tables 1 and 2 below based on 100 parts by weight of the silica particles, respectively. An ultrapure solvent was mixed so that a solid content became 5.01% by weight to prepare a composition for a semiconductor process.

Example 2

A composition for a semiconductor process was prepared in the same manner as in Example 1, except that the weight ratio of the silica surface modifier to the hydrogen ion concentration (pH) adjuster was adjusted to be 2:1.

Example 3

A composition for a semiconductor process was prepared in the same manner as in Example 1, except that the aqueous silica dispersion solution was stirred at a speed of 1900(±100) rpm.

Example 4

A composition for a semiconductor process was prepared in the same manner as in Example 1, except that the weight ratio of the silica surface modifier to the hydrogen ion concentration (pH) adjuster was adjusted to be 3:1.

Comparative Example 1

A composition for a semiconductor process was prepared in the same manner as in Example 1, except that the hydrogen ion concentration (pH) adjuster was first added to the aqueous silica dispersion solution, and then the silica surface modifier was added thereto.

Comparative Example 2

A composition for a semiconductor process was prepared in the same manner as in Example 1, except that the silica surface modifier and the hydrogen ion concentration (pH) adjuster were simultaneously added to the aqueous silica dispersion solution.

Comparative Example 3

A composition for a semiconductor process was prepared in the same manner as in Example 1, except that a hydrogen ion concentration (pH) adjuster having a weight ratio of nitric acid ($HNO_3$) to water ($H_2O$) of 1:1 was prepared.

Comparative Example 4

A composition for a semiconductor process was prepared in the same manner as in Example 1, except that the silica surface modifier was introduced when the temperature of the aqueous silica dispersion solution was 22°C

Comparative Example 5

A composition for a semiconductor process was prepared in the same manner as in Example 1, except that the silica surface modifier was introduced when the temperature of the aqueous silica dispersion solution was 40°C.

Comparative Example 6

A composition for a semiconductor process was prepared in the same manner as in Example 1, except that stirring was performed so that the final reaction temperature of the aqueous silica dispersion solution into which the hydrogen ion concentration (pH) adjuster was introduced became 32 (±4)°C.

Comparative Example 7

A composition for a semiconductor process was prepared in the same manner as in Example 1, except that stirring was performed so that the final reaction temperature of the aqueous silica dispersion solution into which the hydrogen ion concentration (pH) adjuster was introduced became 70 (±5)°C.

**< Evaluation>**

Measurement Example 1: Measurement of hydrogen ion concentration (pH)

The pH was measured using a hydrogen ion concentration (pH) measurer (Laqua, Horiba Co.) while stirring the aqueous silica dispersion solution at 200 rpm under a room temperature condition of 20°C to 24°C.

Measurement Example 2: Measurement of polishing rate

A silicon oxide film wafer having a thickness of about 20,000 Å was prepared for each of the Examples and the comparative examples. As shown in FIG. 1, the wafer, as the polishing target 130, was accommodated in the carrier 160 such that the to-be-polished surface faced downward. After positioning the carrier 160 such that the to-be-polished surface and the polishing surface 111 were in contact with the platen 120 on which a polishing pad 110 (HD-319B, SKC Co.) was mounted such that its polishing surface 111 faced upward, polishing was performed for 60 seconds by operating each component under conditions of a pressing pressure of the carrier 160 against the polishing surface of 2.0 psi, a rotation speed of the carrier 160 of 120 rpm, and a rotation speed of the platen 120 of 120 rpm, while applying the composition for a semiconductor process of each of the Examples and the comparative examples to the polishing surface at a flow rate of 300 ml/min. At the same time, a conditioner 170 (SKC-CI45, Saesol Diamond Co.) was driven under conditions of a rotation speed of 250 rpm and a pressing pressure of 8 psi to process the polishing surface. The thickness of the wafer after polishing was measured, and a polishing rate value (Rox) in unit of Å was calculated using the polishing time and the thicknesses of the wafer before and after polishing. The results are as described in Tables 1 and 2 below.

Measurement Example 3: Measurement of zeta potential

For each of the examples and the comparative examples, a zeta potential (mV) value (ZP1) of the raw silica particles in the aqueous silica dispersion solution before introduction of the silica surface modifier was measured using a zeta potential meter (Malvern Co.), a zeta potential (mV) value (ZP2) of the raw silica particles in the aqueous silica dispersion solution after introduction of the silica surface modifier and before introduction of the hydrogen ion concentration (pH) adjuster was measured with the same equipment, and a zeta potential (mV) value (ZP3) of the silica particles in the final composition for a semiconductor process was measured with the same equipment. The results are as described in Tables 1 and 2 below.

Measurement Example 4: Measurement of LPC value

For each of the examples and the comparative examples, 100 mL of each sample was prepared with respect to the aqueous silica dispersion solution in which the reaction was terminated after adding both the silica surface modifier and the hydrogen ion concentration (pH) adjuster, and aged in a stationary state for 24 hours. Before measuring the sample, lines of the equipment were washed with ultrapure water. LPC values were measured 5 times for the diluted sample under conditions of a diluent flow rate of 15 ml/min, 32 channels, a light extinction collection time of 60 seconds, and an initial concentration of 4000 particles/m using an LPC measuring equipment (Accusizer Fx Nano, PSSA Co.), and the average value was derived. LPC values (RL1, RL3, RL5) of particles having sizes exceeding 1 um, exceeding 3 um, and exceeding 5 um in the aqueous silica dispersion solution are as described in Tables 1 and 2 below.

For each of the examples and comparative Examples, 100 mL of each sample was prepared for the final composition for a semiconductor process and aged in a stationary state for 24 hours. Before measuring the sample, lines of the equipment were washed with ultrapure water. LPC values were measured 5 times for the diluted sample under conditions of a diluent flow rate of 15 ml/min, 32 channels, a light extinction collection time of 60 seconds, and an initial concentration of 4000 particles/m using an LPC measuring equipment (Accusizer Fx Nano, PSSA Co.), and the average value was derived. LPC values (L1, L3, L5) of particles having sizes exceeding 1 um, exceeding 3 um, and exceeding 5 um in the composition for a semiconductor process are as described in Tables 1 and 2 below.

[Table 1]

| Classification | | | Unit | Example 1 | Example 2 | Example 3 | Example 4 | Comparative Example 1 |
|---|---|---|---|---|---|---|---|---|
| Composition | Silica particles | | parts by weight | 100 | 100 | 100 | 100 | 100 |
| | Surface modifier | | parts by weight | 0.1 | 0.2 | 0.1 | 0.3 | 0.1 |
| | pH adjuster | Content | parts by weight | 0.1 | 0.1 | 0.1 | 0.1 | 0.1 |
| | | Dilution ratio | - | 1:10 | 1:10 | 1:10 | 1:10 | 1:10 |
| | Sorbitol | | parts by weight | 50 | 50 | 50 | 50 | 50 |
| | Imidazole | | parts by weight | 1 | 1 | 1 | 1 | 1 |
| | Acetic acid | | parts by weight | 1 | 1 | 1 | 1 | 1 |
| | Fluorine-based | | parts by weight | 0.5 | 0.5 | 0.5 | 0.5 | 0.5 |
| | Solid content | | % by weight | 5.01 | 5.01 | 5.01 | 5.01 | 5.01 |
| Process | Input order | | - | AS > HN | AS > HN | AS > HN | AS > HN | HN > AS |
| | AS input temp | | °C | 35 | 35 | 35 | 35 | 35 |
| | Final reaction temp | | °C | 60(±2) | 60(±2) | 60(±2) | 60(±2) | 60(±2) |
| | Stirring speed | Step (a) | rpm | 1675 (±75) | 1675 (±75) | 1675 (±75) | 1675 (±75) | 1675 (±75) |
| | | Step (b) | rpm | 1675 (±75) | 1675 (±75) | 1900 (±75) | 1675 (±75) | 1675 (±75) |
| Zeta potential | ZP1 | | mV | -25 | -24 | -25 | -25 | -24 |
| | ZP2 | | mV | 28 | 27 | 26 | 28 | 27 |
| | ZP3 | | mV | 23 | 23 | 22 | 24 | 23 |
| | Equation 4 | | - | 10.60 | 12.75 | 12.75 | 13.25 | 12.75 |
| LPC | RL1 | | ea | 2625 | 2256 | 1924 | 3245 | 34254 |
| | RL3 | | ea | 243 | 224 | 206 | 342 | 3384 |
| | RL5 | | ea | 89 | 62 | 41 | 101 | 1167 |
| | L1 | | ea | 229 | 323 | 253 | 296 | 394 |
| | L3 | | ea | 12 | 16 | 15 | 13 | 24 |
| | L5 | | ea | 3 | 9 | 5 | 7 | 14 |
| | Equation 1 | | % | 6.55 | 7.74 | 7.91 | 6.76 | 9.64 |
| | Equation 2 | | % | 6.15 | 7.18 | 7.33 | 6.33 | 8.80 |

(continued)

| Classification | | Unit | Example 1 | Example 2 | Example 3 | Example 4 | Comparative Example 1 |
|---|---|---|---|---|---|---|---|
| Polishing performance | Rox | Å/min | 1922 | 1862 | 1902 | 1523 | 1856 |
| | Ox defect | ea | 624 | 824 | 611 | 1142 | 1321 |
| | Equation 3 | - | 7.88 | 5.35 | 6.97 | 4.82 | 4.30 |

[Table 2]

| Classification | | | Unit | Comparative Example 2 | Comparative Example 3 | Comparative Example 4 | Comparative Example 5 | Comparative Example 6 |
|---|---|---|---|---|---|---|---|---|
| Composition | Silica particles | | parts by weight | 100 | 100 | 100 | 100 | 100 |
| | Surface modifier | | parts by weight | 0.1 | 0.2 | 0.1 | 0.3 | 0.1 |
| | pH adjuster | Content | parts by weight | 0.1 | 0.1 | 0.1 | 0.1 | 0.1 |
| | | Dilution ratio | - | 1:10 | 1:10 | 1:10 | 1:10 | 1:10 |
| | Sorbitol | | parts by weight | 50 | 50 | 50 | 50 | 50 |
| | Imidazole | | parts by weight | 1 | 1 | 1 | 1 | 1 |
| | Acetic acid | | parts by weight | 1 | 1 | 1 | 1 | 1 |
| | Fluorine-based | | parts by weight | 0.5 | 0.5 | 0.5 | 0.5 | 0.5 |
| | Solid content | | % by weight | 5.01 | 5.01 | 5.01 | 5.01 | 5.01 |
| Process | Input order | | - | AS + HN | AS > HN | AS > HN | AS > HN | AS > HN |
| | AS input temp | | °C | 35 | 22 | 40 | 35 | 35 |
| | Final reaction temp | | °C | 60(±2) | 60(±2) | 60(±2) | 32(±4) | 70(±5) |
| | Stirrin g speed | Step (a) | rpm | 1675 (±75) | 1675 (±75) | 1675 (±75) | 1675 (±75) | 1675 (±75) |
| | | Step (b) | rpm | 1675 (±75) | 1675 (±75) | 1675 (±75) | 1675 (±75) | 1675 (±75) |
| Zeta potential | ZP1 | | mV | -25 | -24 | -24 | -24 | -25 |
| | ZP2 | | mV | 25 | 27 | 23 | 24 | 23 |
| | ZP3 | | mV | 21 | 24 | 21 | 19 | 17 |
| | Equation 4 | | - | 12.50 | 17.00 | 23.50 | 9.60 | 8.00 |
| LPC | RL1 | | ea | 24328 | 320449 | 354428 | 82492 | 12439 |
| | RL3 | | ea | 1563 | 3124 | 3652 | 842 | 942 |
| | RL5 | | ea | 435 | 978 | 1421 | 221 | 322 |
| | L1 | | ea | 435 | 814 | 782 | 452 | 455 |
| | L3 | | ea | 48 | 79 | 84 | 65 | 22 |
| | L5 | | ea | 17 | 31 | 27 | 26 | 6 |
| | Equation 1 | | % | 14.94 | 13.51 | 14.19 | 20.13 | 6.15 |
| | Equation 2 | | % | 13.00 | 11.90 | 12.43 | 16.76 | 5.80 |

(continued)

| Classification | | Unit | Comparative Example 2 | Comparative Example 3 | Comparative Example 4 | Comparative Example 5 | Comparative Example 6 |
|---|---|---|---|---|---|---|---|
| Polishing perfor-mance | Rox | Å/min | 1822 | 1322 | 1624 | 1382 | 1868 |
| | Ox defect | ea | 1783 | 20132 | 16247 | 4235 | 2234 |
| | Equation 3 | - | 3.64 | 1.43 | 1.82 | 2.55 | 3.87 |

Referring to Tables 1 and 2, it can be confirmed that, regarding the compositions for a semiconductor process of Examples 1 to 4, the polishing rate for the silicon oxide film was achieved at a target level, and simultaneously, defects after polishing of the silicon oxide film were achieved at a level of less than about 1200, for example, less than about 1100, or, for example, less than about 1000, as the values of Equations 1, 2, and/or 3 satisfied the above-described ranges, respectively.

In the composition for a semiconductor process of Comparative Example 1, the pH adjuster (HN) was introduced first instead of the silica surface modifier (AS) in the order of the preparation process. It can be confirmed that the number of aggregates in the aqueous silica dispersion solution of Comparative Example 1 significantly increased compared to Examples 1 to 4. As a result, it can be confirmed that the values of Equations 1 and 2 of the composition for a semiconductor process finally prepared therefrom deviated from the upper limit ranges, and the polishing performance for the silicon oxide film did not achieve the target level in terms of defects.

In the composition for a semiconductor process of Comparative Example 2, the silica surface modifier and the pH adjuster were introduced simultaneously in the order of the preparation process. It can be confirmed that the number of aggregates in the aqueous silica dispersion solution of Comparative Example 2 significantly increased compared to Examples 1 to 4. As a result, it may be confirmed that the values of Equations 1 and 2 of the composition for a semiconductor process finally prepared therefrom significantly deviated from the upper limit ranges, and the polishing performance for the silicon oxide film did not achieve the target level in terms of defects.

In Comparative Examples 3 and 4, the temperature of the aqueous silica dispersion solution into which the silica surface modifier was introduced during the preparation process of the composition for a semiconductor process was less than 25°C, or 40°C or higher. When the reaction start temperature was lower or higher than the target range as described above, it can be confirmed that the number of aggregates in the aqueous silica dispersion solutions of Comparative Examples 3 and 4 significantly increased compared to Examples 1 to 4. As a result, it can be confirmed that the values of Equations 1 and 2 of the composition for a semiconductor process finally prepared therefrom significantly deviated from the upper limit ranges, and the polishing performance for the silicon oxide film did not achieve the target level in terms of defects.

In Comparative Examples 5 and 6, the final reaction temperature during the preparation process of the composition for a semiconductor process was less than 50°C, or greater than 65°C. When the final reaction temperature was lower or higher than the target range as described above, it can be confirmed that the number of aggregates in the aqueous silica dispersion solutions of Comparative Examples 5 and 6 significantly increased compared to Examples 1 to 4. As a result, it can be confirmed that the values of Equations 1 and 2 of the composition for a semiconductor process finally prepared therefrom deviated from the upper or lower limit ranges, and the polishing performance for the silicon oxide film did not achieve the target level in terms of defects.

## Claims

**1.** A composition for a semiconductor process, comprising silica particles and having a value of 6.30% to 9.60% according to Equation 1 below:

[Equation 1]

$$\frac{(L3+L5)}{L1} \times 100$$

where L1 is a Liquid Particle Counting (LPC) value of particles having a particle diameter of greater than 1 um in the composition for a semiconductor process,
L3 is an LPC value of particles having a particle diameter of greater than 3 um in the composition for a semiconductor process, and
L5 is an LPC value of particles having a particle diameter of greater than 5 um in the composition for a semiconductor process.

**2.** A composition for a semiconductor process, comprising silica particles and having a value of greater than 5.80% and less than 8.80% according to Equation 2 below:

[Equation 2]

$$\frac{(L3+L5)}{(L1+L3+L5)} \times 100$$

where L1 is a Liquid Particle Counting (LPC) value of particles having a particle diameter of greater than 1 um in the composition for a semiconductor process,
L3 is an LPC value of particles having a particle diameter of greater than 3 um in the composition for a semiconductor process, and
L5 is an LPC value of particles having a particle diameter of greater than 5 um in the composition for a semiconductor process.

**3.** The composition according to claim 1 or 2, wherein the composition has a value of 4.50 to 10.00 according to Equation 3 below:

[Equation 3]

$$\frac{Rox}{(L1+L2+L3)}$$

where L1 is an LPC value of particles having a particle diameter of greater than 1 um in the composition for a semiconductor process,
L3 is an LPC value of particles having a particle diameter of greater than 3 um in the composition for a semiconductor process,
L5 is an LPC value of particles having a particle diameter greater than 5 um in the composition for a semiconductor process, and
Rox is a polishing rate (Å/min) value of a silicon oxide film polished under conditions of a polishing pressure of 2 psi using the composition for a semiconductor process, a rotation speed of 120 rpm of a carrier mounted with a polishing target, a rotation speed of 120 rpm of a platen mounted with a polishing pad, and an injection rate of 300 ml/min of the composition for a semiconductor process.

**4.** The composition according to claim 1 or 2, further comprising at least one type of additive,
wherein the additive comprises one selected from the group consisting of an azolebased compound, a fluorine-based compound, an alcohol compound, an organic acid, an inorganic acid, and a combination thereof.

**5.** The composition according to claim 1 or 2, wherein the silica particles have a zeta potential of +10 mV to +40 mV in the composition for a semiconductor process.

**6.** A method of preparing a composition for a semiconductor process, the method comprising:

step (a) of stirring an aqueous silica dispersion solution having a hydrogen ion concentration (pH) in a range of 4.0 to 5.5;
step (b) of introducing a silica surface modifier containing an aminosilane component when a temperature of the aqueous silica dispersion solution is in a range of 25°C or higher and lower than 40°C;
step (c) of introducing a hydrogen ion concentration (pH) adjuster into the aqueous silica dispersion solution into which the silica surface modifier has been introduced; and
step (d) of stirring the aqueous silica dispersion solution, into which the hydrogen ion concentration (pH) adjuster has been introduced, such that a final reaction temperature reaches one in a range of 50°C to 65°C.

**7.** The method of preparing a composition for a semiconductor process according to claim 6, wherein, in step (a), the aqueous silica dispersion solution is stirred at a speed of 500 rpm to 3000 rpm.

**8.** The method of preparing a composition for a semiconductor process according to claim 6, wherein the hydrogen ion concentration (pH) adjuster comprises an acid component and a solvent, wherein a weight ratio of the acid component

to the solvent is 1:1 to 1:15.

**9.** A method of manufacturing a semiconductor device, the method comprising:

disposing a to-be-polished surface of a polishing target to be in contact with a polishing surface of a polishing pad; injecting a composition for a semiconductor process into a contact interface between the polishing surface and the to-be-polished surface; and

polishing the to-be-polished surface while rotating the polishing pad and the polishing target relative to each other, wherein the composition for a semiconductor process has a value of 6.30% to 9.60% according to Equation 1 below:

[Equation 1]

$$\frac{(L3+L5)}{L1} \times 100$$

where L1 is a Liquid Particle Counting (LPC) value of particles having a particle diameter of greater than 1 um in the composition for a semiconductor process,

L3 is an LPC value of particles having a particle diameter of greater than 3 um in the composition for a semiconductor process, and

L5 is an LPC value of particles having a particle diameter of greater than 5 um in the composition for a semiconductor process.

**10.** A method of manufacturing a semiconductor device, the method comprising:

disposing a to-be-polished surface of a polishing target to be in contact with a polishing surface of a polishing pad; injecting a composition for a semiconductor process onto the polishing surface; and

polishing the to-be-polished surface while rotating the polishing pad and the polishing target relative to each other, wherein the composition for a semiconductor process has a value of greater than 5.80% and less than 8.80% according to Equation 2 below:

[Equation 2]

$$\frac{(L3+L5)}{(L1+L3+L5)} \times 100$$

where L1 is a Liquid Particle Counting (LPC) value of particles having a particle diameter of greater than 1 um in the composition for a semiconductor process,

L3 is an LPC value of particles having a particle diameter of greater than 3 um in the composition for a semiconductor process, and

L5 is an LPC value of particles having a particle diameter of greater than 5 um in the composition for a semiconductor process.

**11.** The method according to claim 9 or 10, wherein the composition for a semiconductor process is injected onto the polishing surface at a flow rate of 10 mL/min to 1,000 mL/min.

**12.** The method according to claim 9 or 10, wherein rotation speeds of the polishing pad and the polishing target are each independently 10 rpm to 500 rpm.

【FIG. 1】

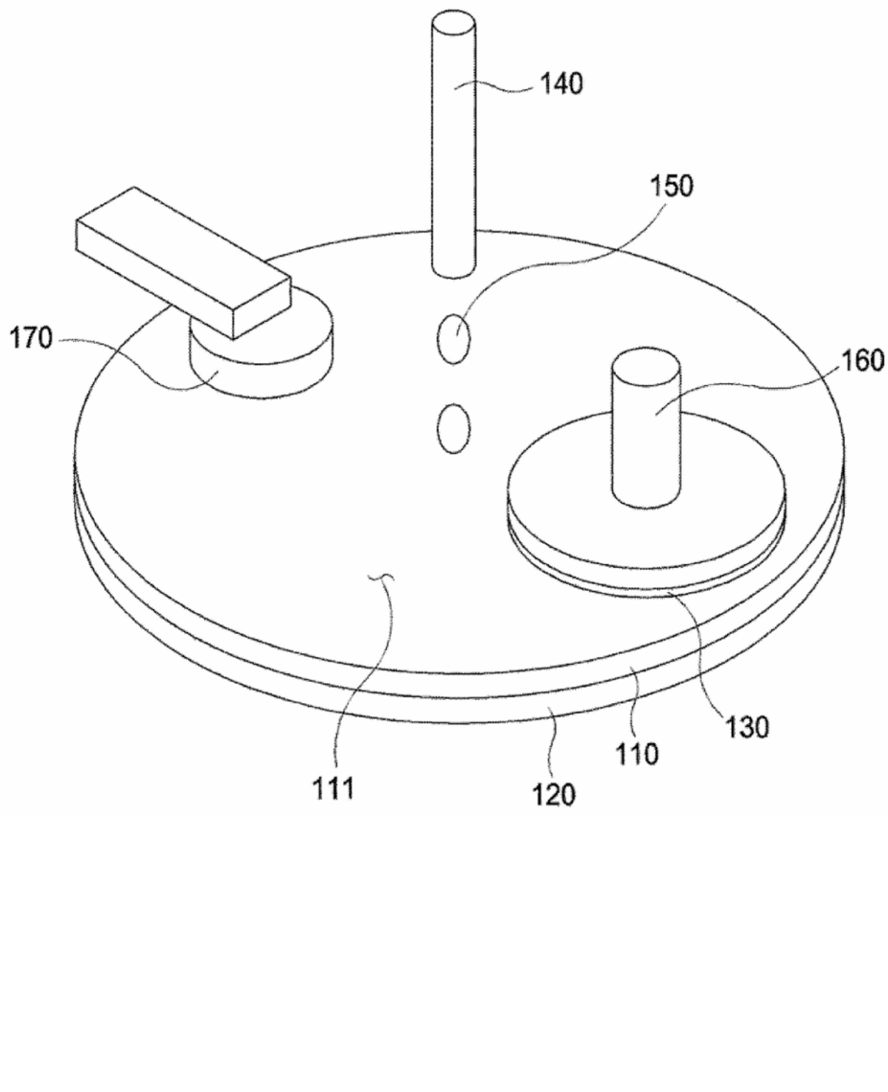

## INTERNATIONAL SEARCH REPORT

International application No.
**PCT/KR2024/006818**

**A. CLASSIFICATION OF SUBJECT MATTER**

**C09G 1/02**(2006.01)i; **C09K 3/14**(2006.01)i; **H01L 21/3105**(2006.01)i; **B24B 37/04**(2006.01)i

According to International Patent Classification (IPC) or to both national classification and IPC

**B. FIELDS SEARCHED**

Minimum documentation searched (classification system followed by classification symbols)

C09G 1/02(2006.01); B24B 37/00(2006.01); C09K 3/14(2006.01); H01L 21/304(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 반도체(semiconductor), 웨이퍼(wafer), 화학적 기계적 연마(chemical mechanical polishing, CMP), 실리카(silica, SiO2)

**C. DOCUMENTS CONSIDERED TO BE RELEVANT**

| Category* | Citation of document, with indication, where appropriate, of the relevant passages | Relevant to claim No. |
|---|---|---|
| X<br>Y | KR 10-2022-0137554 A (SKC SOLMICS CO., LTD.) 12 October 2022 (2022-10-12)<br>See claims 1, 8 and 10; paragraphs [0052]-[0054], [0057], [0058], [0080], [0081], [0086], [0087], [0105]-[0107] and [0135]; and table 2. | 1-5,9-12<br>6-8 |
| Y | JP 2008-288398 A (NIPPON CHEM. IND. CO., LTD. et al.) 27 November 2008 (2008-11-27)<br>See claim 1; and paragraph [0032]. | 6-8 |
| Y | KR 10-2004-0063386 A (CATALYSTS & CHEMICALS INDUSTRIES CO., LTD.) 14 July 2004 (2004-07-14)<br>See claim 4; and example 1. | 6-8 |
| A | KR 10-2022-0094421 A (SKC SOLMICS CO., LTD.) 06 July 2022 (2022-07-06)<br>See claims 1, 4 and 7; and paragraph [0001]. | 1-12 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 September 2024** | **19 September 2024** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

INTERNATIONAL SEARCH REPORT

International application No.
PCT/KR2024/006818

C. DOCUMENTS CONSIDERED TO BE RELEVANT

| Category* | Citation of document, with indication, where appropriate, of the relevant passages | Relevant to claim No. |
|---|---|---|
| A | KR 10-2020-0098708 A (CABOT MICROELECTRONICS CORPORATION) 20 August 2020 (2020-08-20)<br>See claims 1 and 5-8; and paragraph [0012]. | 1-12 |

Form PCT/ISA/210 (second sheet) (July 2022)

**INTERNATIONAL SEARCH REPORT**
**Information on patent family members**

International application No.
**PCT/KR2024/006818**

| Patent document cited in search report | | | Publication date (day/month/year) | Patent family member(s) | | | Publication date (day/month/year) |
|---|---|---|---|---|---|---|---|
| KR | 10-2022-0137554 | A | 12 October 2022 | CN | 115197645 | A | 18 October 2022 |
| | | | | CN | 115197645 | B | 20 February 2024 |
| | | | | EP | 4067449 | A1 | 05 October 2022 |
| | | | | JP | 2022-159256 | A | 17 October 2022 |
| | | | | JP | 7296504 | B2 | 22 June 2023 |
| | | | | TW | 202239892 | A | 16 October 2022 |
| | | | | TW | I823321 | B | 21 November 2023 |
| | | | | US | 2022-0325139 | A1 | 13 October 2022 |
| JP | 2008-288398 | A | 27 November 2008 | US | 2008-0287038 | A1 | 20 November 2008 |
| | | | | US | 7753974 | B2 | 13 July 2010 |
| KR | 10-2004-0063386 | A | 14 July 2004 | | None | | |
| KR | 10-2022-0094421 | A | 06 July 2022 | CN | 114686117 | A | 01 July 2022 |
| | | | | JP | 2022-104814 | A | 11 July 2022 |
| | | | | JP | 7329035 | B2 | 17 August 2023 |
| | | | | TW | 202227585 | A | 16 July 2022 |
| | | | | TW | I815260 | B | 11 September 2023 |
| | | | | US | 2022-0208552 | A1 | 30 June 2022 |
| KR | 10-2020-0098708 | A | 20 August 2020 | CN | 111566175 | A | 21 August 2020 |
| | | | | EP | 3737723 | A1 | 18 November 2020 |
| | | | | JP | 2021-509768 | A | 01 April 2021 |
| | | | | JP | 7370984 | B2 | 30 October 2023 |
| | | | | TW | 201936882 | A | 16 September 2019 |
| | | | | TW | I760589 | B | 11 April 2022 |
| | | | | US | 10647887 | B2 | 12 May 2020 |
| | | | | US | 2019-0211227 | A1 | 11 July 2019 |
| | | | | WO | 2019-136197 | A1 | 11 July 2019 |

Form PCT/ISA/210 (patent family annex) (July 2022)